# EUROPEAN PATENT APPLICATION

(11) **EP 1 895 540 A1**
(43) Date of publication of application: **05.03.2008**
(21) Application number: 05750964.8
(22) Date of filing: 20.06.2005
(51) Int. Cl.: G11C 13/00

(54) **NONVOLATILE SEMICONDUCTOR STORAGE DEVICE AND WRITE METHOD THEREFOR**

(71) Applicant: Fujitsu Ltd., Kawasaki-shi, Kanagawa 211-8588 (JP)
(72) Inventor: KINOSHITA, Kentaro, c/o FUJITSU LIMITED, Kawasaki-shi, Kanagawa 211-8588 (JP)
(74) Representative: Fenlon, Christine Lesley
(86) International application number: PCT/JP2005/011249
(87) International publication number: WO 2006/137111

(57) **Abstract**

A method of writing into a nonvolatile semiconductor memory device including a resistance memory element which memorizes a high resistance state and a low resistance state and switches between the high resistance state and the low resistance state by an application of a voltage, in which when the voltage is applied to the resistance memory element to switch from the high resistance state to the low resistance state, a value of a current to flow in the resistance memory elements are limited to thereby memorize in the resistance memory elements the low resistance state of the low resistance value corresponding to the limited value of the current.

## Description

### TECHNICAL FIELD

The present invention relates to a nonvolatile semiconductor memory device, more specifically, a nonvolatile semiconductor memory device using a resistance memory element having a plurality of resistance states of different resistance values and a method of writing into the same.

### BACKGROUND ART

Recently, as a new memory device, a nonvolatile semiconductor memory device called RRAM (Resistance Random Access Memory) is noted. The RRAM uses a resistance memory element which has a plurality of resistance states of different resistance values, which are changed by electric stimulations applied from the outside and whose high resistance state and low resistance state are corresponded to, e.g., information "0" and "1" to be used as a memory element. The RRAM highly potentially has high speed, large capacities, low electric power consumption, etc. and is considered prospective.

The resistance memory element has a resistance memory material whose resistance states are changed by the application of voltages sandwiched between a pair of electrodes. As the typical resistance memory material, oxide materials containing transition metals are known and, depending on the electric characteristics, can be classified largely in two.

One uses voltages of polarities different from each other so as to change the resistance state between the high resistance state and the low resistance state and includes SrTiO₃ and SrZrO₃, and Pr₁₋ₓCaₓMnO₃, La₁₋ₓCaₓMnO₃, etc., which exhibit CMR (Colossal Magneto- Resistance). The RRAM using such bipolar material is disclosed in, e.g., Patent Reference 1, Non-Patent Reference 1 and Non-Patent Reference 2.

The other uses voltages of the same polarity so as to change the resistance state between the high resistance state and the low resistance state and includes oxides of single transition metals, etc., e.g., NiOₓ, TiOₓ. The RRAM using such unipolar material is disclosed in, e.g., Non-Patent Reference 3.
Patent Reference 1: U.S. Patent No. 6,473,332
Patent Reference 2: Japanese published unexamined patent application No. 2005-025914
Non-Patent Reference 1: A. Beck et al., Appl. Phys. Lett., Vol. 77, p. 139 (2001)
Non-Patent Reference 2: W. W. Zhuang et al., Tech. Digest IEDM 2002, p. 193
Non-Patent Reference 3: 1. G. Baek et al., Tech. Digest IEDM 2004, p. 587

### DISCLOSURE OF INVENTION

### PROBLEMS TO BE SOLVED BY THE INVENTION

In the semiconductor memory device, to increase the memory capacity per a unit area, downsizing of the elements themselves is being studied, and also the multiple-valued memory is being studied. The multiple-valued memory is different from the usual binary memory, in which one memory cell can take either state of "0" and "1" but is a memory element in which one memory cell can take three or more states.

In the RRAM as well, studies of the multiple-valued memory are being made. For example, Patent Reference 1 and Non-Patent Reference 2 disclose that when the amplitude width or the width of the voltage pulse to be applied to bipolar resistance memory materials is varied, corresponding to this, the absolute value of resistance of the low resistance state is varied. The possibility of forming a multiple-valued memory by making use of not only two resistances, a high resistance and a low resistance, but also low resistance states of middle resistances between both resistances and others is also disclosed.

However, by the method of controlling the resistance value by the amplitude width or the width of an applied voltage, it is difficult to realize more than two resistance states with good reproducibility, and the multiple-valued memory using bipolar resistance memory materials has not been realized.

For unipolar resistance memory materials, a report of the binary memory is disclosed only in, e.g., Non-Patent Reference 3, and techniques for the value multiplexing has not been proposed.

In the technique of applying a voltage to the resistance memory element to change the resistance memory material from the high resistance state to the low resistance state, larger current than required for rewriting flows due to the abrupt resistance value decreased. Such large current has been a cause for accelerating the degradation of the resistance memory material.

An object of the present invention is to provide a nonvolatile semiconductor memory device using a resistance memory element which memorizes a plurality of resistance states of different resistance value and a method of writing into the same which can realize two or more resistance states with good reproducibility.

Another object of the present invention is to provide a nonvolatile semiconductor memory device and the method of writing the same which, when the resistance memory element is switched from the high resistance state to the low resistance state, can prevent the flow of large current to the element.

### MEANS FOR SOLVING THE PROBLEMS

According to one aspect of the present invention, there is provided a method of writing into a nonvolatile semiconductor memory device including a resistance memory element which memorizes a high resistance state and a low resistance state and switches between the high resistance state and the low resistance state by an application of a voltage, when the voltage is applied to the resistance memory element to thereby switch from the high resistance state to the low resistance state, a value of a current to flow in the resistance memory element being limited to thereby memorize the low resistance state of a low resistance value corresponding to the limited value of the current.

According to another aspect of the present invention, there is provided a nonvolatile semiconductor memory device comprising; a resistance memory element which memorizes a high resistance state and a low resistance state and switches between the high resistance state and the low resistance state by an application of a voltage; a variable resistor serially connected to the resistance memory element; and a current limitation circuit which, when the voltage is applied to the resistance memory element to switch from the high resistance state to the low resistance stage, a value of a current to flow in the resistance memory element being limited to memorize in the resistance memory element the low resistance state of a low resistance value corresponding to the limited value of the current.

According to further another aspect of the present invention, there is provided a nonvolatile semiconductor memory device comprising: a plurality of memory cells arranged in a matrix, each including a resistance memory element which memorizes a high resistance state and a low resistance state and switches between the high resistance state and the low resistance state by an application of a voltage, and a select transistor having one terminal serially connected to one terminal of the resistance memory element; a plurality of first signal lines parallelly extended in a first direction and each connected to gate electrodes of the select transistors of the memory cells arranged in the first direction; a plurality of second signal lines parallelly extended in a second direction intersecting the first direction and each connected to the other terminals of the resistance memory elements of the memory cells arranged in the second direction; a plurality of third signal lines parallelly extended in the first direction and each connected to the other terminals of the select transistors of the memory cells arranged in the first direction; variable resistors serially connected to the other terminals of the resistance memory elements; and a current limitation circuit which, when a voltage is applied to the resistance memory element to switch from the high resistance state to the low resistance state, controls a value of a current to flow in the resistance memory element to thereby memorize in the resistance memory element the low resistance state of a low resistance value corresponding to the limited value of the current.

### EFFECT OF THE INVENTION

According to the present invention, in a nonvolatile semiconductor memory device using a resistance memory element which memorizes a plurality of resistance states of different resistance values, when the resistance memory element is switched from a high resistance state to a low resistance state, a resistor is serially connected to the resistance memory element to thereby prevent the flow of large current in the resistance memory element, whereby the breakage of the resistance memory element due to the flow of large current can be prevented. The resistance value of the resistance memory element in the low resistance state can be controlled by resistance values of the resistance element. Thus, multiple-valued memory can be easily realized.

### BRIEF DESCRIPTION OF DRAWINGS

[FIG. 1] FIG. 1 is a graph showing the current-voltage characteristics of the resistance memory element using a bipolar resistance memory material.
[FIG. 2] FIG. 2 is a graph showing the current-voltage characteristics of the resistance memory element using a unipolar resistance memory material.
[FIG. 3] FIG. 3 is a graph showing the current-voltage characteristics of the unipolar resistance memory material with changing the set value of the current limiter.
[FIG. 4] FIG. 4 is a graph showing the current-voltage characteristics of the resistance memory element using the unipolar resistance memory material, which explains the forming process thereof.
[FIG. 5] FIG. 5 is a circuit diagram showing the structure of the nonvolatile semiconductor memory device according to a first embodiment of the present invention (Part 1).
[FIG. 6] FIG. 6 is a circuit diagram showing the structure of the nonvolatile semiconductor memory device according to a first embodiment of the present invention (Part 1).
[FIG. 7] FIG. 7 is a time chart showing the method of writing into the nonvolatile semiconductor memory device according to the first embodiment of the present invention (Part 1).
[FIG. 8] FIG. 8 is a time chart showing the method of writing into the nonvolatile semiconductor memory device according to the first embodiment of the present invention (Part 2).
[FIG. 9] FIG. 9 is a time chart showing the method of reading the nonvolatile semiconductor memory device according to the first embodiment of the present invention.
[FIG. 10] FIG. 10 is a circuit diagram showing the structure of the nonvolatile semiconductor memory device according to a third embodiment of the present invention (Part 1).
[FIG. 11] FIG. 11 is a circuit diagram showing the structure of the nonvolatile semiconductor memory device according to a third embodiment of the present invention (Part 2).
[FIG. 12] FIG. 12 is a circuit diagram showing the structure of the nonvolatile semiconductor memory device and the method of writing into the same according to a fifth embodiment of the present invention.
[FIG. 13] FIG. 13 is a plan view showing the structure of the nonvolatile semiconductor memory device according to a sixth embodiment of the present invention.
[FIG. 14] FIG. 14 is a diagrammatic sectional view showing the structure of the nonvolatile semiconductor memory device according to the sixth embodiment of the present invention.
[FIG. 15] FIG. 15 is sectional views showing the method of manufacturing the nonvolatile semiconductor memory device according to the sixth embodiment of the present invention (Part 1).
[FIG. 16] FIG. 16 is sectional views showing the method of manufacturing the nonvolatile semiconductor memory device according to the sixth embodiment of the present invention (Part 2).
[FIG. 17] FIG. 17 is a circuit diagram showing the structure of the nonvolatile semiconductor memory device according to a modification of the embodiments of the present invention (Part 1).
[FIG. 18] FIG. 18 is a circuit diagram showing the structure of the nonvolatile semiconductor memory device according to a modification of the embodiments of the present invention (Part 2).

### EXPLANATION OF REFERENCE NUMERALS

- 10: memory cell
- 12: resistance memory element
- 14: cell select transistor
- 16: bit line select transistor
- 18: current limit transistor
- 20: silicon substrate
- 22: device isolation film
- 24, 30: gate electrode
- 26, 28, 32, 34: source/drain region
- 36, 56, 64: inter-layer insulating film
- 38, 40, 42, 44, 58, 60, 66: contact plug
- 46: source line
- 48: lower electrode
- 50: resistance memory material layer
- 52: upper electrode
- 54: resistance memory element
- 62: interconnection layer
- 68: bit line

### BEST MODE FOR CARRYING OUT THE INVENTION

### [A First Embodiment]

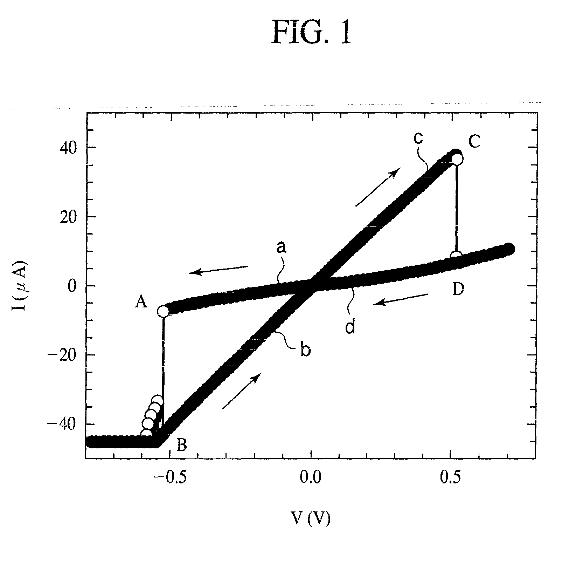

The nonvolatile semiconductor memory device and method of writing into the same according to a first embodiment of the present invention will be explained with reference to FIGs. 1 to 9.

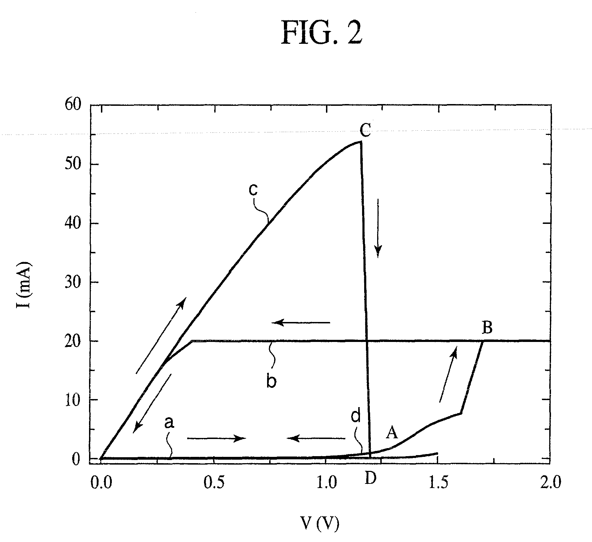

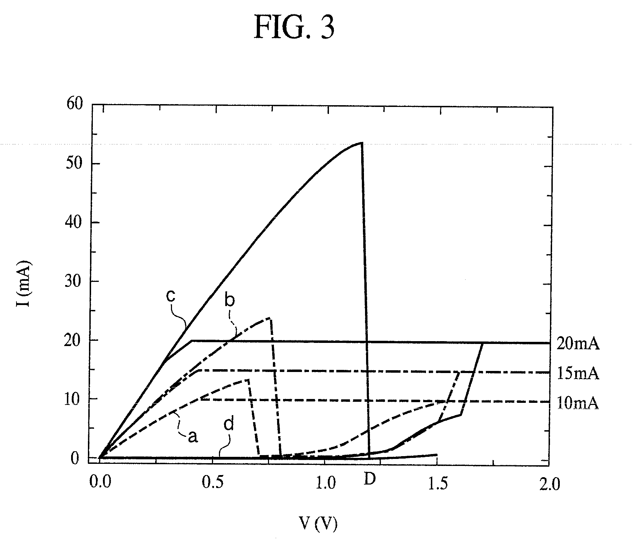

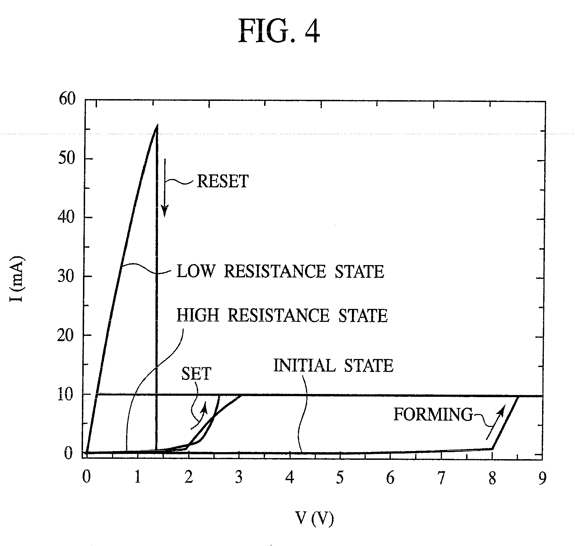

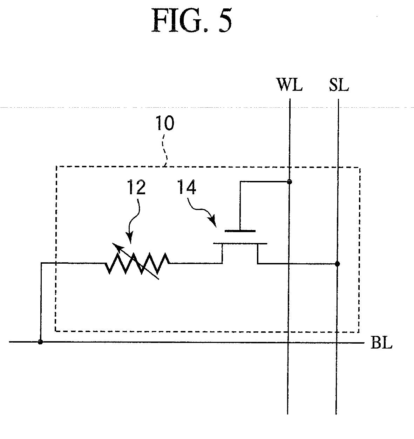

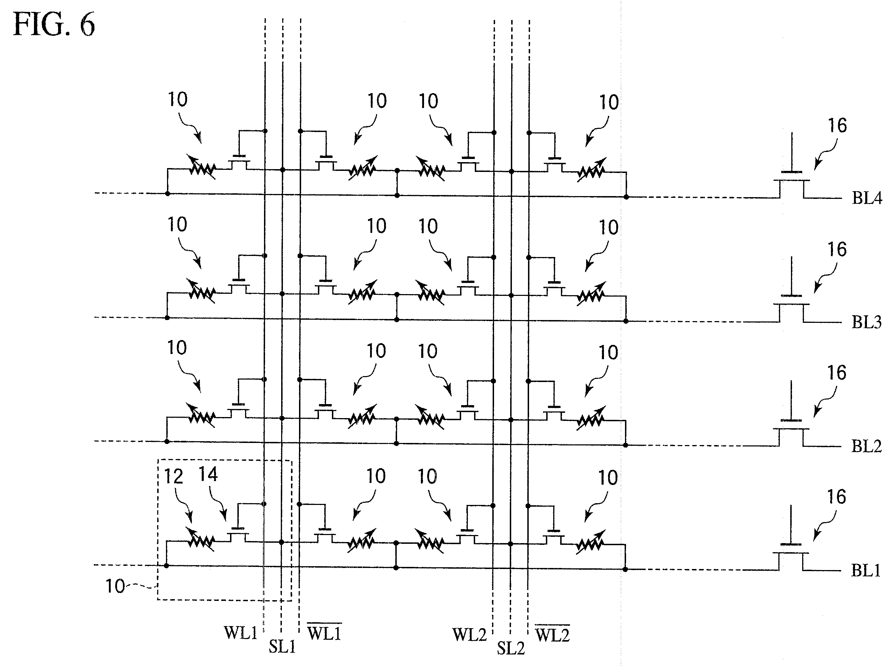

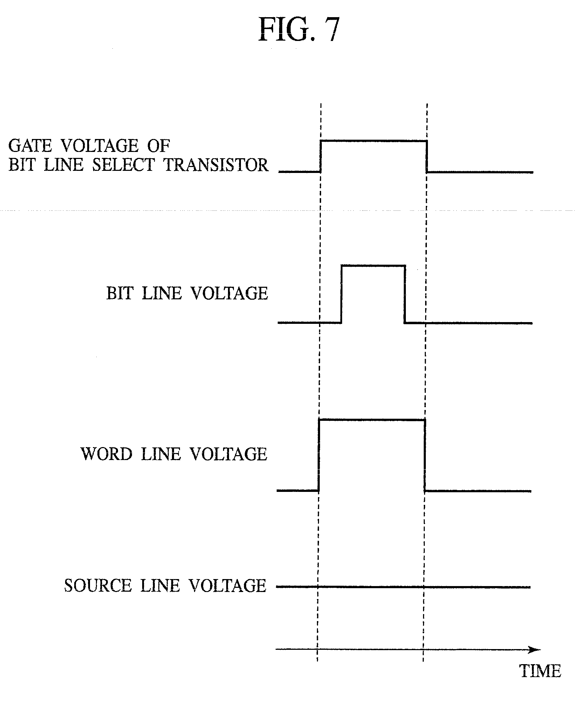

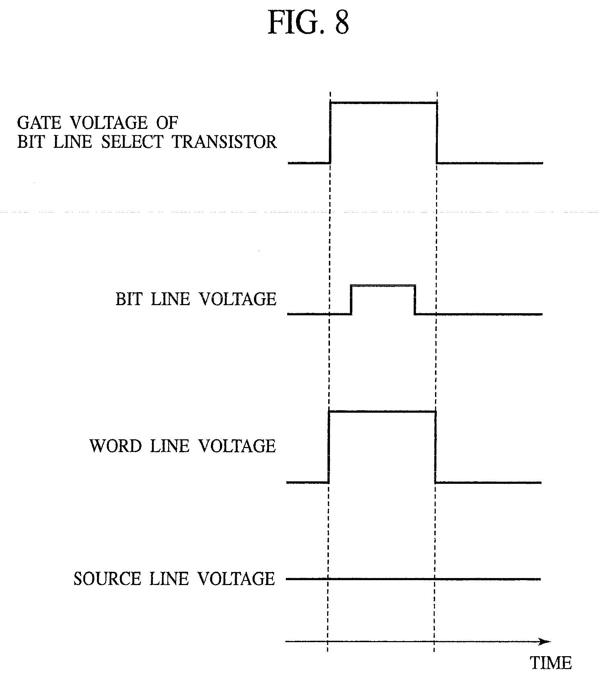

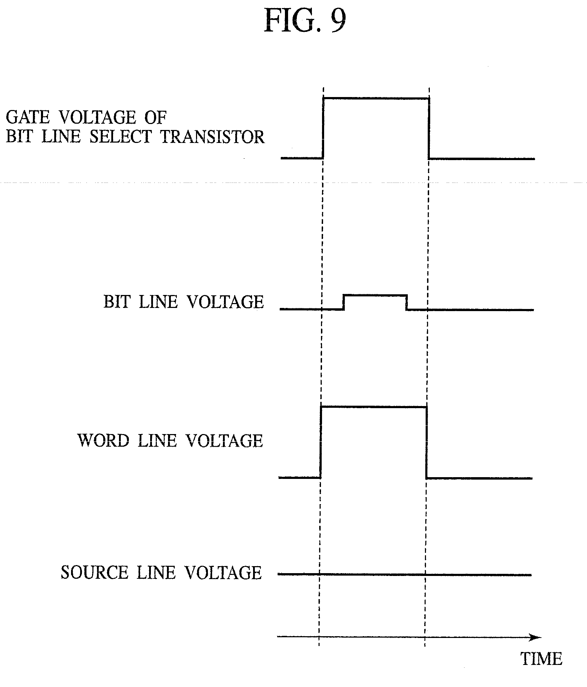

FIG. 1 is a graph showing the current-voltage characteristics of the resistance memory element using a bipolar resistance memory material. FIG. 2 is a graph showing the current-voltage characteristics of the resistance memory element using a unipolar resistance memory material. FIG. 3 is a graph showing the current-voltage characteristics of the unipolar resistance memory material with changing the set value of the current limiter. FIG. 4 is a graph showing the current-voltage characteristics of the resistance memory element using the unipolar resistance memory material, which explains the forming process thereof. FIGs. 5 and 6 are circuit diagrams showing the structure of the nonvolatile semiconductor memory device according to the present embodiment. FIGs. 7 and 8 are time charts showing the method of writing into the nonvolatile semiconductor memory device according to the present embodiment. FIG. 9 is a time chart showing the method of reading the nonvolatile semiconductor memory device according to the present embodiment.

First, the basic operation of the resistance memory element will be explained with reference to FIGs. 1 and 2.

The resistance memory element includes the resistance memory material sandwiched between a pair of electrodes. Many of the resistance memory material are oxide materials containing transition metals, and the resistance memory material is divided largely in two, depending on differences in the electric characteristics.

One of them uses voltages of different polarities so as to change the resistance states between the high resistance state and the low resistance state and includes SrTiO₃ and SrZrO₃ doped with a trace of an impurity, such as chrome (Cr) or others, and Pr₁₋ₓCaₓMnO₃ and La₁₋ₓCaₓMnO₃, etc., which exhibit CMR (Colossal Magneto-Resistance). Such resistance memory material which requires voltages of different polarities so as to rewrite the resistance state will be hereinafter called the bipolar resistance memory material.

The other of them is materials which require voltages of the same polarity so as to change the resistance states between the high resistance state and the low resistance state and includes oxides, etc., containing a single transition metal, such as NiOₓ and TiOₓ. Such resistance memory materials which require voltages of the same polarity for rewriting the resistance states will be hereinafter called the unipolar resistance memory material.

FIG. 1 is a graph of the current-voltage characteristics of the resistance memory element using the bipolar resistance memory material and is disclosed in Non-Patent Reference 1. This graph is of the resistance memory element using Cr-doped SrZrO₃, which is the typical bipolar resistance memory material.

It is assumed that in the initial state, the resistance memory element is in the high resistance state.

As an applied voltage increases gradually from 0 V to negative voltages, the current flowing at this time changes along the curve "a" in the arrowed direction, and its absolute value gradually increases. When the applied negative voltage is further increased and exceed about -0.5 V, the resistance memory element switches from the high resistance state to the low resistance state. Accompanying this, the absolute value of the current abruptly increases, and the current-voltage characteristics transits from the point A to the point B. In the following explanation, the operation of changing the resistance memory element from the high resistance state to the low resistance state is called "set".

As the negative voltage is gradually decreased from the state at the point B, the current changes along the curve "b" in the arrowed direction, and its absolute value gradually decreases. When the applied voltage returns to 0 V, the current also becomes 0 A.

As the applied voltage increases gradually from 0 V to positive voltages, the current value changes along the curve "c" in the arrowed direction, and its absolute values gradually increases. The applied positive voltage further increases and exceeds about 0.5 V, the resistance memory element switches from the low resistance state to the high resistance state. Accompanying this, the absolute value of the current abruptly decreases, and the current-voltage characteristics transit from the point C to the point D. In the following explanation, the operation of changing the resistance memory element from the low resistance state to the high resistance state is called "reset".

As the positive voltage decreases from the state at the point D, the current changes along the curve "d" in the arrowed direction, and its absolute value gradually decreases. When the applied voltage returns to 0 V, the current also becomes 0 A.

The respective resistance states are stable in the range of about ±0.5 V and can be retained even when the electric power source is turned off. That is, in the high resistance state, when an applied voltage is lower than the absolute value of the voltage at the point A, the current-voltage characteristics changes linearly along the curves "a" and "d", and the high resistance state is retained. Similarly, in the low resistance state, when an applied voltage is lower than the absolute value of the voltage at the point C, the current-voltage characteristics changes linearly along the curves "b" and "c", and the low resistance state is retained.

As described above, for the resistance memory element using the bipolar resistance memory material, to change the resistance state between the high resistance state and the low resistance state, voltages of different polarities are applied.

FIG. 2 is a graph of the current-voltage characteristics of the resistance memory element using the unipolar resistance memory material. This graph is of the resistance memory element using TiOₓ, which is the typical unipolar resistance memory material.

It is assumed that in the initial state, the resistance memory element is in the high resistance state.

As an applied voltage is increased gradually from 0 V, the current increases along the curve "a" in the arrowed direction, and its absolute value gradually increases. When the applied voltage gradually increases and exceeds about 1.3 V, the resistance memory element is switched from the high resistance state to the low resistance state (set). Accompanying this, the absolute value of the current abruptly increases, and the current-voltage characteristics transit from the point A to the point B. In FIG. 2, the current value at the point B is constantly about 20 mA because of the current limiter for preventing the element from breaking due to abrupt current increases.

As the voltage decreases gradually from the state at the point B, the current changes along the curve "b" in the arrowed direction, and its absolute value gradually decreases. When the applied voltage returns to 0 V, the current also becomes 0 A.

As the applied voltage again increases gradually from 0 V, the current changes along the curve "c" in the arrowed direction, and its absolute value gradually increases. When the applied positive voltage further increases and exceeds about 1.2 V, the resistance memory element is switched from the low resistance state to the high resistance state (reset). Accompanying this, the absolute value of the current abruptly decreases, and the current-voltage characteristics transits from the point C to the point D.

As the voltage is decreased gradually from the point D, the current changes in the arrowed direction along the curve "d", and the absolute value is gradually decreased. When the applied voltage returns to 0 V, the current also becomes 0 A.

The respective resistance states are stable not more than about 1.0 V and are retained when the electric power is turned off. That is, in the high resistance state, when the applied voltage is below the voltage at the point A, the current-voltage characteristics linearly change along the curve "a", and the high resistance state is retained. Similarly, in the low resistance state, when the applied voltage is below the voltage at the point C, the current-voltage characteristics change along the curve "c", and the low resistance state is retained.

As described above, in the resistance memory element using the unipolar resistance memory material, to change the resistance state between the high resistance state and the low resistance state, voltages of the same polarity are applied.

As described above, because of the abrupt change of the resistance value in setting the resistance memory element at the low resistance state, there is a risk that the flowing current might be abruptly increased to break the element. Accordingly, it is preferable to provide a current limiter for prohibiting the current of above a prescribed value to the element when the resistance memory element is set at the low resistance state. The current limiter can be realized simply by connecting serially to the resistance memory element a resistor having a resistance value which cannot be ignored with respect to a resistance value of the resistance memory element in the low resistance state.

The inventor of the present application made earnest studies of this current limiter, it has been evident for the first time that a resistance value with the resistance memory element set at the low resistance state can be controlled by a set value of the current limiter. By means of the resistance memory element using a unipolar resistance memory material, a method of controlling the resistance value by the set value of the current limiter will be explained.

FIG. 3 is a graph of the current-voltage characteristics of the resistance memory element with the set value of the current limiter changed to 10 mA, 15 mA and 20 mA. In the graph, the dot line is for the 10 mA, the one dot chain line is for the 15 mA, and the solid line is for the 20 mA.

As shown in FIG. 3, with the set value of the current limiter changed, the current-voltage characteristics of the resistance memory element change. With the set value of the current limiter being 10 mA, as the applied voltage is decreased after setting at the low resistance state, the current value goes on decrease along the curve "a" and returns to the origin. With the set value of the current limiter being 15 mA, as the applied voltage is decreased after setting at the low resistance state, the current value goes on decrease along the curve "b" steeper than the curve "a" and returns to the origin. With the set value of the current limiter being 20 mA, as the applied voltage is decreased, the current value goes on decrease along the curve "c" steeper than the curve "b" and returns to the origin.

As the voltage is gradually increased again after having returned to the origin, with the set value of the current limiter being 10 mA, the current value goes on increase along the curve "a", with the set value of the current limiter being 15 mA, the current value goes on increase along the curve "b", and with the set value of the current limiter being 20 mA, the current value goes on increase along the curve "c". That is, the resistance memory element is set at a smaller resistance value as the set value of the current limiter is larger.

As the applied voltage is further increased, the current value abruptly decreases, and the resistance memory element is reset at the high resistance state. Then, as the applied voltage is decreased, the current value goes on decrease along the curve "d" and returns to the origin. The voltage necessary for the reset is, as shown in FIG. 3, higher as the set value of the current limiter for the setting is higher.

As described above, the set value of the current limiter in setting the resistance memory element at the low resistance state is changed, whereby the resistance value of the resistance memory element in the low resistance state can be controlled. The resistance value at this time can be preserved unless the resistance memory element is reset. Thus, the set value of the current limiter is changed to thereby set the resistance memory element, whereby the resistance memory element can be used a multiple-valued memory.

The resistance memory element formed of the above-described material cannot have the characteristics shown in FIGs. 1 and 2 in the initial state immediately after the element formation. To make the resistance memory material reversibly changeable between the high resistance state and the low resistance state, the processing called "forming" is necessary.

FIG. 4 shows the current-voltage characteristics explaining the forming process of the resistance memory element using the same unipolar resistance memory material as in FIGs. 2 and 3.

In the initial state immediately after the element has been formed, as shown in FIG. 4, the element is highly resistive and has a breakdown voltage of about 8 V which is very high. This breakdown voltage is very high in comparison with voltages necessary for the setting and resetting. In the initial state, changes of the resistance state, such as the setting and resetting, do not take place.

When a voltage higher than the breakdown voltage is applied in the initial state, as shown in FIG. 4, the value of the current flowing through the element abruptly increases, that is, the forming of the resistance memory element is made. Such forming is made, whereby the resistance memory element exhibits the current-voltage characteristics shown in FIG. 2 and can switch reversibly between the low resistance state and the high resistance state. Once subjected to the forming, the resistance memory element does not return to the initial state.

The resistance memory element in the initial state before subjected to the forming has a high resistance value, and this high resistance state might be misunderstood to be the high resistance state after the forming. Then, in the specification of the present application, the high resistance state means the high resistance state of the resistance memory element after subjected to the forming, the low resistance state means the low resistance state of the resistance memory element after subjected to the forming, and the initial state is the state of the resistance memory element before subjected to the forming.

The above-explanation has been made for the unipolar resistance memory material, but the explanation is the same with the bipolar resistance memory material.

Next, the structure of the nonvolatile semiconductor memory device according to the present embodiment will be explained with reference to FIGs. 5 and 6.

FIGs. 5 and 6 are circuit diagrams showing the structure of the nonvolatile semiconductor memory device according to the present embodiment.

As shown in FIG. 5, a memory cell 10 of the nonvolatile semiconductor memory device according to the present embodiment includes a resistance memory element 12 and a cell select transistor 14. The resistance memory element 12 has one end connected to a bit line BL and the other end connected to the drain terminal of the cell select transistor 14. The cell select transistor 14 has the source terminal connected to a source line SL and the gate terminal connected to a word line WL.

The resistance memory element 12 includes a resistance memory material sandwiched between a pair of electrodes. The resistance memory material may be a bipolar resistance memory material or a unipolar resistance memory material. In the present embodiment, the resistance memory material is a unipolar resistance material of, e.g. TiOₓ.

FIG. 6 is a circuit diagram of a memory cell array of the memory cells 10 shown in FIG. 5 arranged in a matrix. A plurality of memory cells 10 are formed adjacent to each other in the column direction (vertically in the drawing) and in the row direction (horizontally in the drawing).

In the column direction, a plurality of word lines WL1, /WL1, WL2, /WL2 ... are arranged, forming signal lines common among the memory cells 10 arranged in the column direction. In the column direction, source lines SL1, SL2 ... are arranged, forming signal lines common among the memory cells 10 arranged column direction. The source lines SL are provided each for two word lines WL.

In the row direction (horizontally in the drawing), a plurality of bit lines BL1, BL2, BL3, BL4 ... are arranged, forming signal lines common among the memory cells 10 arranged in the row direction. To each bit line BL, a bit line select transistor 16 as a variable resistor is connected.

Next, the method of writing into the nonvolatile semiconductor memory device according to the present embodiment shown in FIG. 6 will be explained with reference to FIGs. 7 and 8.

First, the rewriting operation from the high resistance state to the low resistance state, i.e.., the setting operation will be explained with reference to FIG. 7. A memory cell 10 to be rewritten is a memory cell 10 connected to the word line WL1 and the bit line BL1.

First, a prescribed voltage is applied to the gate terminal of the bit line select transistor 16 connected to the bit line BL1 to turn on the bit line select transistor 16 (refer to FIG. 7). At this time, the voltage to be applied to the gate terminal is controlled so that a channel resistance R_{BS} of the bit line select transistor 16 has a value which is sufficiently smaller than a resistance value R_{H} of the resistance memory element 12 in the high resistance state and is not negligible in comparison with a resistance value R_{L} of the resistance memory element 12 in the low resistance state.

Simultaneously with turning on the bit line select transistor 16, a prescribed voltage is applied to the word line WL1 to turn on the cell select transistor 14 (refer to FIG. 7). At this time, the voltage to be applied to the word line WL1 is controlled so that a channel resistance R_{CS} of the cell select transistor 14 has a value which is negligibly small in comparison with the resistance value R_{L} of the resistance memory element 12 in the low resistance state.

The source line SL is connected to a reference voltage, e.g., 0 V, which is the ground potential (refer to FIG. 7).

Next, to the drain terminal of the bit line select transistor 16, a bias voltage which is the same as a voltage required to set the resistance memory element 12 or a little larger than the voltage is applied (refer to FIG. 7). Thus, a current passage to the source line SL1 via the bit line select transistor 16, the bit line BL1, the resistance memory element 12 and the cell select transistor 14 is formed, and the applied bias voltage is divided to the bit line select transistor 16 and the cell select transistor 14 corresponding to the channel resistance R_{BS} of the bit line select transistor 16 and the channel resistance R_{cs} of the cell select transistor 14.

At this time, the resistance value R_{H} of the resistance memory element 12 is sufficiently large in comparison with the channel resistance R_{BS} of the bit line select transistor 16 and the channel resistance R_{CS} of the cell select transistor, and most of the bias voltage is applied to the resistance memory element 12. Thus, the resistance memory element 12 is changed from the high resistance state to the low resistance state.

When the resistance value of the resistance memory element 12 is changed from the resistance value R_{H} to the resistance value R_{L}, the channel resistance R_{BS} of the bit line select transistor 16 becomes unignorably large in comparison with the resistance value R_{L}, and the ratio of the voltages to be divided to the resistance memory element 12 and the bit line select transistor 16 becomes R_{L} : R_{BS}. Accordingly, the gate voltage of the bit line select transistor 16 is set so that the channel resistance R_{BS} of the bit line select transistor 16 becomes, e.g., R_{BS} = 2 × R_{L}, whereby 1/3 of the bias voltage is divided to the resistance memory element 12.

The channel resistance R_{BS} of the bit line select transistor 16 can be set at an arbitrary value as far as the performance of the bit line select transistor 16 permits, which permits the voltage to be applied to the resistance memory element 12, i.e., the current flowing through the resistance memory element 12 to be set at an arbitrary value by the gate voltage of the bit line select transistor 16.

In short, the current flowing in the resistance memory element 12 can be limited to a prescribed value by the gate voltage of the bit line select transistor 16, and by this current limitation, the resistance value of the resistance memory element 12 can be controlled. For example, as shown in FIG. 3, the value of the current flowing in the resistance memory element 12 is limited to not more than 10 mA, whereby the resistance memory element 12 has the resistance characteristics indicated by the curve "a", and the value of the current flowing in the resistance memory element 12 is limited to not more than 15 mA, whereby the resistance memory element 12 has the resistance characteristics indicated by the curve "b", and the value of the current flowing in the resistance memory element 12 is limited to not more than 15 mA, whereby the resistance memory element has the resistance characteristics indicated by the curve "c''.

Then, after the bias voltage to be applied to the bit line BL1 is returned to zero, the voltage to be applied to the gate terminal of the bit line select transistor 16 and the voltage to be applied to the word line WL are turned off, and the setting operation is completed (refer to FIG. 7).

When the low resistance state having a first resistance value is rewritten to the low resistance state having a second resistance value, after the resetting operation to be described later has been made, the resistance memory element 12 is set anew at the low resistance state of the second resistance value.

Next, the rewriting operation from the low resistance state to the high resistance state, i.e., resetting operation will be explained with reference to FIG. 8. A memory cell 10 to be rewritten is the memory cell 10 connected to the word line WL1 and the bit line BL1.

First, a prescribed voltage is applied to the gate terminal of the bit line select transistor 16 connected to the bit line BL1 to turn on the bit line select transistor 16 (refer to FIG. 8). At this time, the voltage to be applied to the gate terminal is controlled so that the channel resistance R_{BS} of the bit line select transistor 16 becomes sufficiently smaller than the resistance value R_{L} of the resistance memory element 12 in the low resistance state.

Simultaneously with turning on the bit line select transistor 16, a prescribed voltage is applied o the word line WL1 to turn on the cell select transistor 14 (refer to FIG. 8). At this time, the voltage to be applied to the word line WL1 is controlled so that the channel resistance R_{cs} of the cell select transistor 14 becomes sufficiently smaller than the resistance value R_{L} of the resistance memory element 12 in the low resistance state.

The source line SL1 is connected to a reference potential, e.g., 0 V, which is the ground potential (refer to FIG. 8).

Next, to the drain terminal of the bit line select transistor 16, a bias voltage which is the same as or a little larger than the voltage necessary to reset the resistance memory element 12 is applied (refer to FIG. 8). Thus, a current passage to the source line SL1 via the bit line BL1, the resistance memory element 12 and the cell select transistor 14 is formed, and the applied bias voltage is divided to the resistance memory element 12, the bit line select transistor 16 and the cell select transistor 14, corresponding to the resistance value R_{L} of the resistance memory element 12, the channel resistance R_{BS} of the bit line select transistor 16 and the channel resistance R_{cs} of the cell select transistor 14.

At this time, the channel resistance R_{BS} of the bit line select transistor 16, and channel resistance R_{CS} of the cell select transistor 14 are sufficiently smaller than the resistance value R_{L} of the resistance memory element 12, and most of the applied bias voltage is applied to the resistance memory element 12. Thus, the resistance memory element 12 is changed from the low resistance state to the high resistance state.

Thus, in the resetting process, instantaneously with the resistance memory element 12 having switched to the high resistance state, almost all the bias voltage is divided to the resistance memory element 12, and it is necessary to prevent the resistance memory element 12 from being set again by this bias voltage. To this end, the bias voltage to be applied to the bit line BL must be smaller than a voltage necessary for the setting.

In short, in the resetting process, the gate voltages of these transistors are adjusted so that the channel resistance R_{BS} of the bit line select transistor 16 and the channel resistance R_{CS} of the cell select transistor 14 are sufficiently smaller than the resistance value R_{L} of the resistance memory element 12 while the bias voltage to be applied to the bit line BL is set to be not less than the voltage necessary for the resetting and less than the voltage necessary for the setting.

Then, after the bias voltage to be applied to the bit line BL has been returned to zero, the voltage to be applied to the gate terminal of the bit line select transistor 16 and the voltage to be applied to the word line WL are turned off, and the resetting operation is completed (refer to FIG. 8).

In the nonvolatile semiconductor memory device according to the present embodiment, as shown in FIG. 6, the word lines WL and the source lines SL are arranged column direction, and the memory cells 10 connected to one word line (e.g., WL1) are connected to the same source line SL (e.g., SL1). In the resetting operation described above, a plurality of bit lines BL (e.g., BL1 - BL4) are simultaneously driven, whereby a plurality of the memory cells 10 connected to a select word line (e.g., WL1) can be reset at once.

Then, the method of reading the nonvolatile semiconductor memory device according to the present embodiment shown in FIG. 6 will be explained with reference to FIG. 9. The memory cell to be read is a memory cell 10 connected to the word line WL1 and the bit line BL1.

First, a prescribed voltage is applied to the gate terminal of the bit line select transistor 16 to turn on the bit line select transistor 16 (refer to FIG. 9). At this time, the voltage to be applied to the gate terminal is controlled so that the channel resistance R_{BS} of the bit line select transistor 16 is sufficiently smaller than the resistance value R_{L} of the resistance memory element 12.

Simultaneously with turning on the bit line select transistor 16, a prescribed voltage is applied to the word line WL1 to turn on the cell select transistor 14 (refer to FIG. 9). At this time, the voltage to be applied to the word line WL is controlled so that the channel resistance R_{cs} of the cell select transistor 14 is sufficiently smaller than the resistance value R_{L} of the resistance memory element 12 in the low resistance state.

The source line SL1 is connected to a reference potential, e.g., 0 V, which is the ground potential (refer to FIG. 9).

Next, a prescribed bias voltage is applied to the drain terminal of the bit line select transistor 16 (refer to FIG. 9). This bias voltage is set in accordance with the memory characteristics given by the lowest current limitation value. That is, the value of the bias voltage is set so that even with the resistance memory element in any resistance state, neither the setting nor the resetting is caused by the applied voltage.

For example, when the resistance memory element 12 has the current-voltage characteristics shown in FIG. 3, and the lowest current limitation value is, e.g., 10 mA, neither the setting nor the resetting is caused by the bias voltage of not more than about 0.6 V. Accordingly, the bias voltage for reading is set at a voltage which ensures a sufficient margin at a voltage of not more than 0.6 V (e.g., 0.5 V).

When such bias voltage is applied to the drain terminal of the bit line select transistor 16, current corresponding to a resistance value of the resistance memory element 12 flows in the bit line BL1. Accordingly, the value of the current flowing in the bit line BL1 is detected, whereby it can be read what resistance state the resistance memory element 12 has.

As described above, according to the present embodiment, when the resistance memory element is switched from the high resistance state to the low resistance state, the resistor is serially connected to the resistance memory element to thereby prevent the flow of large current to the resistance memory element, whereby the breakage and degradation of the resistance memory element due to the flow of the large current can be prevented. By the resistance value of the resistor, the resistance value of the resistance memory element in the low resistance state can be controlled. Thus, the multiple-valued memory can be easily realized.

### [A Second Embodiment]

The nonvolatile semiconductor memory device and the method of writing into the same according to a second embodiment of the present invention will be explained. The same members of the present embodiment as those of the nonvolatile semiconductor memory device, the method of writing into the same and the method of reading the same according to the first embodiment shown in FIGs. 1 to 9 are represented by the same reference numbers not to repeat or to simplify their explanation.

The nonvolatile semiconductor memory device according to the present embodiment is the same as the nonvolatile semiconductor memory device according to the first embodiment shown in FIGs. 5 and 6 except that in the former, the resistance memory element 12 is formed of a bipolar resistance memory material. The bipolar resistance memory material can be, e.g., Cr-doped SrZrO₃ or others. In the nonvolatile semiconductor memory device according to the present embodiment, as shown in, e.g., FIG. 1, a negative bias voltage is applied upon the setting, and a positive bias voltage is applied upon the resetting.

Next, the method of writing into the nonvolatile semiconductor memory device according to the present embodiment will be explained. The method of writing into the nonvolatile semiconductor memory device according to the present embodiment is basically the same as the method of writing into the nonvolatile semiconductor memory device according to the first embodiment except the polarity of the bias voltage.

First, the rewriting operation from the high resistance state to the low resistance state, i.e., the setting operation will be explained. The memory cell 10 to be rewritten is a memory cell 10 connected to a word line WL1 and to a bit line BL1.

First, a prescribed voltage is applied to the gate terminal of the bit line select transistor 16 connected to the bit line BL1 to turn on the bit line select transistor 16. At this time, the voltage to be applied to the gate terminal is controlled so that the channel resistance R_{BS} of the bit line select transistor 16 is sufficiently smaller than the resistance value R_{H} of the resistance memory element 12 in the high resistance state and has a value which cannot be ignored in comparison with the resistance value R_{L} of the resistance memory element 12 in the low resistance state.

Simultaneously with turning on the bit line select transistor 16, a prescribed voltage is applied to the word line WL1 to turn on the cell select transistor 14. At this time, the voltage to be applied to the word line WL1 is controlled so that the channel resistance R_{CS} of the cell select transistor 14 has a small value which can be ignored in comparison with the resistance value R_{L} of the resistance memory element 12 in the low resistance state.

The source line SL is connected to a reference potential, e.g., 0 V, which is the ground potential.

Then, to the drain terminal of the bit line select transistor 16, a negative bias voltage which is the same as the voltage necessary to set the resistance memory element 12 or whose absolute value is a little larger than the voltage is applied. Thus, a current passage from the source line SL1 via the cell select transistor 14, the resistance memory element 12, the bit line BL1 and the bit line select transistor 16 is formed, and the applied bias voltage is divided to the resistance memory element 12, the bit line select transistor 16 and the cell select transistor 14, corresponding to the resistance value R_{H} of the resistance memory element 12, the channel resistance R_{BS} of the bit line select transistor 16 and the channel resistance R_{CS} of the cell select transistor 14.

At this time, the resistance value R_{H} of the resistance memory element 12 is sufficiently large in comparison with the channel resistance R_{BS} of the bit line select transistor 16 and the channel resistance R_{CS} of the cell select transistor, and most of the bias voltage is applied to the resistance memory element 12. Thus, the resistance memory element 12 is changed from the high resistance state to the low resistance state.

When the resistance value of the resistance memory element 12 has been changed from the resistance value R_{H} to the resistance value R_{L}, the channel resistance R_{BS} of the bit line select transistor 16 becomes unigonorably large in comparison with the resistance value R_{L}, and the ratio of the voltage to be divided to the resistance memory element 12 and the bit line select transistor 16 becomes R_{L} : R_{BS}. Accordingly, with the gate voltage of the bit line select transistor 16 set so that the channel resistance R_{BS} of the bit line select transistor 16 becomes, e.g., R_{BS} = 2 × R_{L}, 1/3 of the bias voltage is divided to the resistance memory element 12.

The channel resistance R_{BS} of the bit line select transistor 16 can be set at an arbitrary value as far as the performance of the bit line select transistor 16 permits, which permits the voltage to be applied to the resistance memory element 12, i.e., the current flowing through the resistance memory element 12 to be set at an arbitrary value by the gate voltage of the bit line select transistor 16. In short, the current to flow in the resistance memory element 12 can be limited to a prescribed value by the gate voltage of the bit line select transistor 16, and by this current limitation, the resistance value of the resistance memory element 12 can be controlled.

Next, after the bias voltage to be applied to the bit line BL1 has been returned to zero, the voltage to be applied to the gate terminal of the bit line select transistor 16 and the voltage to be applied to the word line WL1 are turned off, and the setting operation is completed.

Then, the operation of rewriting from the low resistance state to the high resistance state, i.e., the resetting operation will be explained. The memory cell to be rewritten is a memory cell 10 connected to the word line WL1 and the bit line BL1.

First, a prescribed voltage is applied to the gate terminal of the bit line select transistor 16 connected to the bit line BL1 to turn on the bit line select transistor 16. At this time, the voltage to be applied to the gate terminal is controlled so that the channel resistance R_{BS} of the bit line select transistor 16 becomes sufficiently smaller than the resistance value R_{L} of the resistance memory element 12 in the low resistance state.

Simultaneously with turning on the bit line select transistor 16, a prescribed voltage is applied to the word line WL1 to turn on the cell select transistor 14. At this time, the voltage to be applied to the word line WL1 is controlled so that the channel resistance R_{CS} of the cell select transistor 14 becomes sufficiently smaller than the resistance value R_{L} of the resistance memory element 12 in the low resistance state.

The source line SL1 is connected to a reference potential, e.g., 0 V, which is the ground potential.

Next, to the drain terminal of the bit line select transistor 16, a positive bias voltage which is the same as the voltage necessary to reset the resistance memory element 12 or has an absolute value which is a little large than the voltage is applied. Thus, a current passage from the source line SL1 via the cell select transistor 14, the resistance memory element 12, the bit line BL1 and the bit line select transistor 16 is formed, and the applied bias voltage is divided to the resistance memory element 12, the bit line select transistor 16 and the cell select transistor 14, corresponding to the resistance value R_{L} of the resistance memory element 12, the channel resistance R_{BS} of the bit line select transistor 16 and the channel resistance R_{CS} of the cell select transistor 14.

At this time, the channel resistance R_{BS} of the bit line select transistor 16 and the channel resistance R_{CS} of the cell select transistor 14 are sufficiently smaller than the resistance value R_{L} of the resistance memory element 12, whereby most of the applied bias voltage is applied to the resistance memory element 12. Thus, the resistance memory element 12 changes from the low resistance state to the high resistance state.

Then, after the bias voltage to be applied to the bit line BL1 has been returned to zero, the voltage to be applied to the gate terminal of the bit line select transistor 16 and the voltage to be applied to the word line WL1 are turned off, and the resetting operation is completed.

In the nonvolatile semiconductor memory device according to the present embodiment, as shown in FIG. 6, the word lines WL and the source lines SL are arranged column direction, and the memory cells 10 connected to one word line (e.g., WL1) are connected to the same source line SL (e.g., SL1). In the resetting operation described above, a plurality of bit lines BL (e.g., BL1 - BL4) are simultaneously driven, whereby a plurality of the memory cells 10 connected to a select word line (e.g., WL1) can be reset at once.

Next, the method of reading the nonvolatile semiconductor memory device according to the present embodiment will be explained. The memory cell 10 to be read is the memory cell 10 connected to the word line WL1 and the bit line BL1.

First, a prescribed voltage is applied to the gate terminal of the bit line select transistor 16 to run on the bit line select transistor 16. At this time, the voltage to be applied to the gate terminal is controlled so that the channel resistance R_{BS} of the bit line select transistor 16 becomes sufficiently smaller than the resistance value R_{L} of the resistance memory element 12.

Simultaneously with turning on the bit line select transistor 16, a prescribed voltage is applied to the word line WL1 to turn on the cell select transistor 14. At this time, the voltage to be applied to the word line WL1 is controlled so that the channel resistance R_{CS} of the cell select transistor 14 is sufficiently smaller than the resistance value R_{L} of the resistance memory element 12 in the low resistance state.

The source line SL1 is connected to a reference potential, e.g., 0 V, which is the ground potential.

Next, to the drain terminal of the bit line select transistor 16, a prescribed bias voltage is applied. This bias voltage is set in accordance with memory characteristics given by the lowest current limitation value. That is, the value of the bias voltage is set so that even with the resistance memory element 12 in any resistance state, neither the setting nor the resetting is caused by the applied voltage.

When such bias voltage is applied to the drain terminal of the bit line select transistor 16, current corresponding to a resistance value of the resistance memory element 12 flows in the bit line BL1. Accordingly, the value of the current flowing in the bit line BL1 is detected, whereby it can be read what resistance state the resistance memory element 12 has.

As described above, according to the present embodiment, when the resistance memory element is switched from the high resistance state to the low resistance state, the resistor is serially connected to the resistance memory element to thereby prevent the flow of large current to the resistance memory element, whereby the breakage and degradation of the resistance memory element due to the flow of the large current can be prevented. By the resistance value of the resistor, the resistance value of the resistance memory element in the low resistance state can be controlled. Thus, the multiple-valued memory can be easily realized.

### [A Third Embodiment]

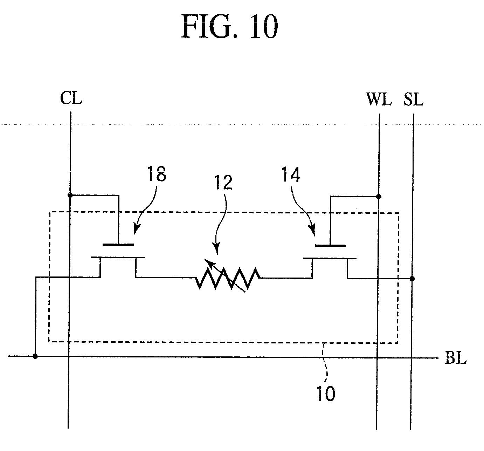

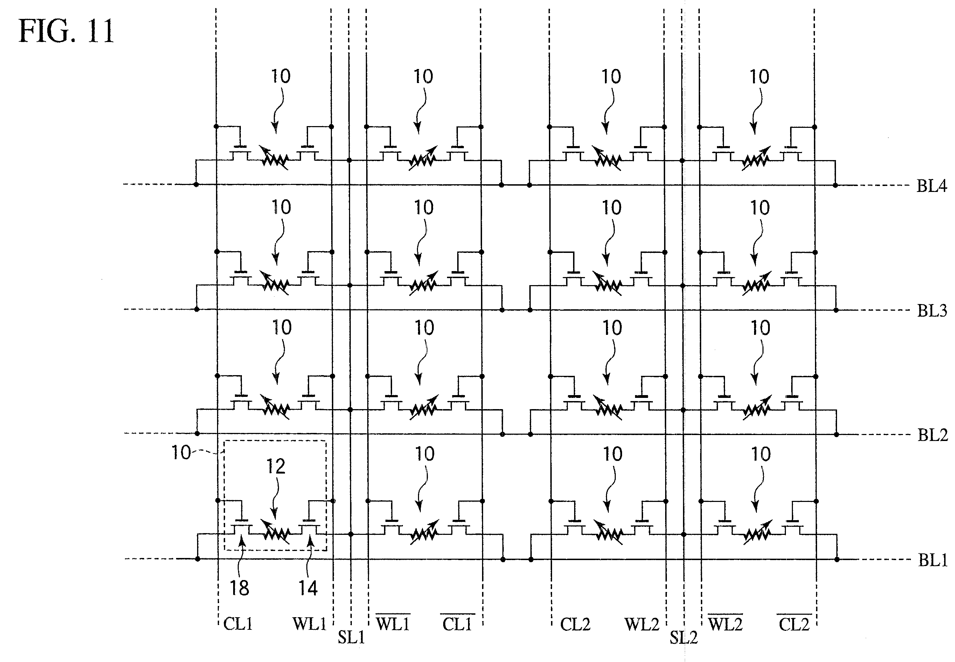

The nonvolatile semiconductor memory device and method of writing into the same according to a third embodiment of the present invention will be explained with reference to FIGs. 10 and 11. The same members of the present embodiment as those of the nonvolatile semiconductor memory device and the method of writing into the same according to the first embodiment shown in FIGs. 1 to 9 are represented by the same reference numbers not to repeat or to simplify their explanation.

FIGs. 10 and 11 are circuit diagrams showing the structure of the nonvolatile semiconductor memory device according to the present embodiment.

First, the structure of the nonvolatile semiconductor memory device according to the present embodiment will be explained with reference to FIGs. 10 and 11.

The memory cell 10 of the nonvolatile semiconductor memory device according to the present embodiment includes, as shown in FIG. 10, a resistance memory element 12, a cell select transistor 14, and a current control transistor 18 as a variable resistor. The resistance memory element 12 has one end connected to the drain terminal of the cell select transistor 14 and the other end connected to the source terminal of the current control transistor 18. The cell select transistor 14 has the source terminal connected to a source line SL and the gate terminal connected to a word line WL. The current control transistor has the drain terminal connected to a bit line BL and the gate terminal connected to a control line CL.

The resistance memory element 12 has a resistance memory material sandwiched between a pair of electrodes. The resistance memory material may be a unipolar resistance memory material or a unipolar resistance memory material. In the present embodiment, the resistance memory material is, e.g., a unipolar resistance material of, e.g., TiOₓ.

FIG. 11 is a circuit diagram of the memory cell array of the memory cells 10 arranged in a matrix. A plurality of memory cells 10 is formed adjacent to each other in the column direction (vertically in the drawing) and the row direction (horizontally in the drawing).

In the column direction, a plurality of word lines WL1, /WL1, WL2, /WL2 ..., control lines CL1, /CL1, CL2, /CL2 ..., and source lines SL1, SL2 ... are arranged, forming signal lines common among the memory cells 10 arranged in the column direction. The source lines SL are provided each for two word lines WL.

In the row direction (horizontally in the drawing), a plurality of bit lines BL1, BL2, BL3, BL4 ... are arranged, forming signal lines common among the memory cells 10 arranged row direction.

Next, the method of writing into the nonvolatile semiconductor memory device according to the present embodiment shown in FIG. 11 will be explained with reference to FIGs. 7 and 8. The voltage of the control lines CL in the present embodiment corresponds to the gate voltage of the bit line select transistor in FIGs. 7 and 8.

First, the operation of rewriting from the high resistance state to the low resistance state, i.e., the setting operation will be explained with reference to FIG. 7. The memory cell 10 to be rewritten is a memory cell 10 connected to the word line WL1 and the bit line BL1.

First, a prescribed voltage is applied to the control line CL1 to turn on the current control transistor 16 (refer to FIG. 7). At this time, the voltage to be applied to the control line CL1 is controlled so that the channel resistance R_{CL} of the current control transistor 18 is sufficiently smaller than the resistance value R_{H} of the resistance memory element 12 in the high resistance state and has a value which cannot be ignored in comparison with the resistance value R_{L} of the resistance memory element 12 in the low resistance state.

Simultaneously with turning on the current control transistor 18, a prescribed voltage is applied to the word line WL1 to turn on the cell select transistor 14 (refer to FIG. 7). At this time, the voltage to be applied to the word line WL1 is controlled so that the channel resistance R_{CS} of the cell select transistor 14 has a value which is ignorably small in comparison with the resistance value R_{L} of the resistance memory element 12 in the low resistance state.

The source line SL1 is connected to a reference potential, e.g., 0 V, which is the ground potential (refer to FIG. 7).

Next, to the bit line BL1, a bias voltage which is the same as the voltage necessary to set the resistance memory element 12 or a little larger than the voltage is applied (refer to FIG. 7). Thus, a current passage to the source line SL1 via the bit line BL1, the current control transistor 18, the resistance memory element 12 and the cell select transistor 14 is formed, and the applied bias voltage is divided to the resistance memory element 12, the current control transistor 16 and the cell select transistor 14, corresponding to the resistance value R_{H} of the resistance memory element 12, the channel resistance R_{CL} of the current control transistor 16 and the channel resistance R_{CS} of the cell select transistor 14.

At this time, the resistance value R_{H} of the resistance memory element 12 is sufficiently large in comparison with the channel resistance R_{CL} of the current control transistor 18 and the channel resistance R_{CS} of the cell select transistor, and most the bias voltage is applied to the resistance memory element 12. Thus, the resistance memory element 12 changes from the high resistance state to the low resistance state.

When the resistance value of the resistance memory element 12 changed from the resistance value R_{H} to the resistance value R_{L}, the channel resistance R_{CL} of the current control transistor 18 becomes unignorably large in comparison with the resistance value R_{L}, and the ratio of the voltages divided to the resistance memory element 12 and the current control transistor 18 becomes R_{L} : R_{CL}. Accordingly, the voltage of the control line CL1 is set so that the channel resistance R_{CL} of the current control transistor 16 becomes, e.g., R_{CL} = 2 × R_{L}, whereby 1/3 of the bias voltage is divided to the resistance memory element 12.

The channel resistance R_{CL} of the current control transistor 18 can be set at an arbitrary value as far as the performance of the current control transistor 18 permits, and the voltage to be applied to the resistance memory element 12, i.e., the current to flow in the resistance memory element 12 can be set at an arbitrary value by the gate voltage of the current control transistor 18, i.e., the applied voltage to the control line CL1.

That is, by the voltage of the control line CL1, the current to flow in the resistance memory element 12 can be limited to a prescribed value, and by this current limitation, the resistance value of the resistance memory element 12 can controlled. For example, as shown in FIG. 3, the value of the current to flow in the resistance memory element 12 is limited to not more than 10 mA, whereby the resistance memory element 12 has the resistance characteristics indicated by the curve "a", and the value of the current to flow in the resistance memory element 12 is limited to not more than 15 mA, whereby the resistance memory element 12 has the resistance characteristics indicated by the curve "b", and the value of the current flowing in the resistance memory element 12 is limited to not more than 20 mA, whereby the resistance memory element 12 has the resistance characteristics indicated by the curve "c".

Next, after the bias voltage to be applied to the bit line BL1 has been returned to zero, the voltages to be applied to the control lines CL1 and the word line WL1 are turned off, and the setting operation is completed (refer to FIG. 7).

Then, the rewriting operation from the low resistance state to the high resistance state, i.e., the resetting operation will be explained with reference to FIG. 8. The memory cell 10 to be rewritten is a memory cell 10 connected to the word line WL1 and the bit line BL1.

First, a prescribed voltage is applied to the control line CL1 to turn on the current control transistor 18 (refer to FIG. 8). At this time, the voltage to be applied to the control line CL1 is controlled so that the channel resistance R_{CL} of the current control transistor 18 is sufficiently smaller than the resistance value R_{L} of the resistance memory element 12 in the low resistance state.

Simultaneously with turning on the current control transistor 18, a prescribed voltage is applied to the word line WL1 to turn on the cell select transistor 14 (refer to FIG. 8). At this time, the voltage to be applied to the word line WL1 is controlled so that the channel resistance R_{CS} of the cell select transistor 14 is sufficiently smaller than the resistance value R_{L} of the resistance memory element 12 in the low resistance state.

The source line SL1 is connected to a reference potential, e.g., 0 V, which is the ground potential (refer to FIG. 8).

Next, to the bit line BL1, a bias voltage which is the same as or a little larger than the voltage necessary to reset the resistance memory element 12 is applied (refer to FIG. 8). Thus, a current passage to the source line SL1 via the bit line BL1, the current control transistor 18, the resistance memory element 12 and the cell select transistor 14 is formed, and the applied bias voltage is divided to the resistance memory element 12, the current control transistor 18 and the cell select transistor 14, corresponding to the resistance value R_{L} of the resistance memory element 12, the channel resistance R_{CL} of the current control transistor 18 and the channel resistance R_{CS} of the cell select transistor 14.

At this time, the channel resistance R_{CL} of the current control transistor 18 and the channel resistance R_{CS} of the cell select transistor 14 are sufficiently smaller than the resistance value R_{L} of the resistance memory element 12, and most of the applied bias voltage is applied to the resistance memory element 12. Thus, the resistance memory element 12 changes from the low resistance state to the high resistance state.

In resetting process, instantaneously with the resistance memory element 12 having changed to the high resistance state, almost all of the bias voltage is divided to the resistance memory element 12, and accordingly it is necessary to prevent the resistance memory element 12 from being set again by this bias voltage. To this end, the bias voltage to be applied to the bit line BL must be smaller than the voltage necessary for the setting.

In short, to make the resetting process, the gate voltages of these transistors are adjusted so that the channel resistance R_{CL} of the current control transistor 18 and the channel resistance R_{CS} of the cell select transistor 14 are sufficiently smaller than the resistance value R_{L} of the resistance memory element 12 while the bias voltage to be applied to the bit line BL is set to be not less than the voltage necessary for the resetting and less than the voltage necessary for the setting.

Then, after the bias voltage to be applied to the bit line BL1 has been returned to zero, the voltage to be applied to the control line CL1 and the voltage to be applied to the word line WL1 are turned off, and the resetting operation is completed (refer to FIG. 8).

In the nonvolatile semiconductor memory device according to the present embodiment, as shown in FIG. 6, the word lines WL and the source lines SL are arranged in column direction, and the memory cells 10 connected to one word line (e.g., WL1) are connected to the same source line SL (e.g., SL1). In the resetting operation described above, a plurality of bit lines BL (e.g., BL1 - BL4) are simultaneously driven, whereby a plurality of memory cells 10 connected to a select word line (e.g., WL1) can be reset at once.

Next, the method of reading the nonvolatile semiconductor memory device according to the present embodiment shown in FIG. 11 will be explained with reference to FIG. 9. The memory cell to be read is a memory cell 10 connected to the word line WL1 and the bit line BL1.

First, a prescribed voltage is applied to the control line CL1 to turn on the current control transistor 18 (refer to FIG. 9). At this time, the voltage to be applied to the control line CL1 is controlled so that the channel resistance R_{CL} of the current control transistor 18 is sufficiently smaller than the resistance value R_{L} of the resistance memory element 12.

Simultaneously with turning on the current control transistor 18, a prescribed voltage is applied to the word line WL1 to turn on the cell select transistor 14 (refer to FIG. 9). At this time, the voltage to be applied to the word line WL1 is controlled so that the channel resistance R_{cs} of the cell select transistor 14 is sufficiently smaller than the resistance value R_{L} of the resistance memory element 12 in the low resistance state.

The source line SL1 is connected to a reference potential, e.g., 0 V, which is the ground potential (refer to FIG. 9).

Next, a prescribed bias voltage is applied to the bit line BL1 (refer to FIG. 9). This bias voltage is set in accordance with the memory characteristics given by the lowest current limitation value. That is, the value of the bias voltage is set so that even with the resistance memory element 12 having any resistance state, neither the setting nor the resetting is caused by the applied voltage.

For example, when the resistance memory element 12 has the current-voltage characteristics shown in FIG. 3 and the lowest current limitation value is, e.g., 10 mA, neither the setting nor the resetting is caused by the bias voltage of not more than 0.6 V. Accordingly, the bias voltage for reading is set at a voltage of less than 0.6 V (e.g., 0.5 V) which sufficiently ensures a margin.

When such bias voltage is applied to the bit line BL1, current corresponding to the resistance value of the resistance memory element 12 flows in the bit line BL. Accordingly, the value of the current flowing in the bit line BL1 is detected, whereby it can be read what resistance state the resistance memory element 12 has.

As described above, according to the present embodiment, when the resistance memory element is switched from the high resistance state to the low resistance state, the resistor is serially connected to the resistance memory element to thereby prevent the flow of large current to the resistance memory element, whereby the breakage and degradation of the resistance memory element due to the flow of the large current can be prevented. By the resistance value of the resistor, the resistance value of the resistance memory element in the low resistance state can be controlled. Thus, the multiple-valued memory can be easily realized.

### [A Fourth Embodiment]

The nonvolatile semiconductor memory device and the method of writing into the same according to a fourth embodiment of the present invention will be explained. The same members of the present embodiment as those of the nonvolatile semiconductor memory device, the method of writing into the same and the method of reading the same according to the third embodiment shown in FIGs. 10 and 11 are represented by the same reference numbers not to repeat or to simplify their explanation.

The nonvolatile semiconductor memory device according to the present embodiment is the same as the nonvolatile semiconductor memory device according to the third embodiment shown in FIGS. 10 and 11 except that in the former, the resistance memory element 12 is formed of a bipolar resistance memory material. The bipolar resistance memory material can be, e.g., Cr-doped SrZrO₃ or others. In the resistance memory element of the nonvolatile semiconductor memory device according to the present embodiment, as shown in, e.g., in FIG. 1, a negative bias voltage is applied for the setting, and for the resetting, a positive bias voltage is applied.

Next, the method writing into the nonvolatile semiconductor memory device according to the present embodiment will be explained. The method of writing into the nonvolatile semiconductor memory device according to the present embodiment is the same as the method of writing into the nonvolatile semiconductor memory device according to the third embodiment except the polarity of the bias voltage.

First, the operation of rewriting from the high resistance state to the low resistance state, i.e., the setting operation will be explained. The memory cell 10 to be rewritten is a memory cell 10 connected to the word line WL1 and to the bit line BL1.

First, a prescribed voltage is applied to the control line CL1 to turn on the current control transistor 18. At this time, the voltage to be applied to the control line CL1 is controlled so that the channel resistance R_{CL} of the current control transistor 18 is sufficiently smaller than the resistance value R_{H} of the resistance memory element 12 in the high resistance state and has a value which is cannot be ignored in comparison with the resistance value R_{L} of the resistance memory element 12 in the low resistance state.

Simultaneously with turning on the current control transistor 18, a prescribed voltage is applied to the word line WL1 to turn on the cell select transistor 14. At this time, the voltage to be applied to the word line WL1 is controlled so that the channel resistance R_{CS} of the cell select transistor 14 has a value which is ignorably small in comparison with the resistance value R_{L} of the resistance memory element 12 in the low resistance state.

The source line SL1 is connected to a reference potential, e.g., 0 V, which is the ground potential.

Then, to the bit line BL1, a negative bias voltage which is the same as the voltage necessary to setting the resistance memory element 12 or has an absolute value a little larger than the voltage is applied. Thus, a current passage from the source line SL1 via the cell select transistor 14, the resistance memory element 12, the current control transistor 18 and the bit line BL1 is formed. The applied voltage is divided to the resistance memory element 12, the current control transistor 18 and the cell select transistor 14, corresponding to the resistance value R_{H} of the resistance memory element 12, the channel resistance R_{CL} of the current control transistor 18 and the channel resistance R_{CS} of the cell select transistor 14.

At this time, the resistance value R_{H} of the resistance memory element 12 is sufficiently large in comparison with the channel resistance R_{CL} of the current control transistor 18 and the channel resistance R_{CS} of the cell select transistor 14, and most of the bias voltage is applied to the resistance memory element 12. Thus, the resistance memory element 12 changes from the high resistance state to the low resistance state.

When the resistance value of the resistance memory element 12 changes from the resistance value R_{H} to the resistance value R_{L}, the channel resistance R_{CL} of the current control transistor 18 becomes unignorably large in comparison with the resistance value R_{L}, and the ratio of the voltages divided to the resistance memory element 12 and the current control transistor 18 becomes R_{L} : R_{CL}. Accordingly, the voltage of the control line CL1 is set so that the channel resistance R_{CL} of the current control transistor 18 becomes, e.g., R_{CL} = 2 × R_{L}, whereby 1/3 of the bias voltage is divided to the resistance memory element 12.

The channel resistance R_{CL} of the current control transistor 18 can be set at an arbitrary value as far as the performance of the current control transistor 18 permits, and the voltage to be applied to the resistance memory element 12, i.e., current to flow in the resistance memory element 12 can be set at an arbitrary value by the gate voltage of the current control transistor 18, i.e., the applied voltage to the control line CL1. In short, by the voltage of the control line CL1, the current to flow in the resistance memory element 12 can be limited to a prescribed value. By this current limitation, the resistance value of the resistance memory element 12 can be controlled.

Then, after the bias voltage to be applied to the bit line BL1 has been returned to zero, the voltage to be applied to the control line CL1 and voltage to be applied to the word line WL1 are turned off, and the setting operation is completed.

Then, the rewriting operation from the low resistance state to the high resistance state, i.e., the resetting operation will be explained. The memory cell 10 to be rewritten is a memory cell 10 connected to the word line WL1 and the bit line BL1.

First, a prescribed voltage is applied to the control line CL1 to turn on the current control transistor 18. At this time, the voltage to be applied to the control line CL1 is controlled so that the channel resistance R_{CL} of the current control transistor 18 becomes sufficiently smaller than the resistance value R_{L} of the resistance memory element 12 in the low resistance state.

Simultaneously with turning on the current control transistor 18, a prescribed voltage is applied to the word line WL1 to turn on the cell select transistor 14. At this time, the voltage to be applied to the word line WL1 is controlled so that the channel resistance R_{CS} of the cell select transistor 14 becomes sufficiently smaller than the resistance value R_{L} of the resistance memory element 12 in the low resistance state.

The source line SL1 is connected to a reference potential, e.g., 0 V, which is the ground potential.

Then, to the bit line BL1, a positive bias voltage which is the same as or has an absolute value larger than the voltage necessary to reset the resistance memory element 12 is applied. Thus, a current passage from the source line SL1 via the cell select transistor 14, the resistance memory element 12, the current control transistor 18 and the bit line BL1 is formed, and the applied bias voltage is divided to the resistance memory element 12, the current control transistor 18 and the cell select transistor 14, corresponding to the resistance value R_{L} of the resistance memory element 12, the channel resistance R_{CL} of the current control transistor 18 and the channel resistance R_{CS} of the cell select transistor 14.

At this time, the channel resistance R_{BS} of the current control transistor 18 and channel resistance R_{CS} of the cell select transistor 14 are sufficiently smaller than the resistance value R_{L} of the resistance memory element 12, which permits almost all the applied bias voltage is applied to the resistance memory element 12. Thus, the resistance memory element 12 changes from the low resistance state to the high resistance state.

Next, after the bias voltage to be applied to the bit line BL1 has been returned to zero, the voltage to be applied to the control line CL1 and the voltage to be applied to the word line WL1 are turned off, and the setting operation is completed.

In the nonvolatile semiconductor memory device according to the present embodiment, as shown in FIG. 11, the word lines WL and the source lines SL are arranged in column direction, and the memory cells 10 connected to one word line (e.g., WL1) are connected to the same source line SL (e.g., SL1). In the resetting operation described above, a plurality of bit lines BL (e.g., BL1 - BL4) are simultaneously driven, whereby a plurality of memory cells 10 connected to a select word line (e.g., WL1) can be reset at once.

Next, the method of reading the nonvolatile semiconductor memory device according to the present embodiment will be explained. The memory cell 10 to be read is a memory cell 10 connected to the word line WL1 and the bit line BL1.

First, a prescribed voltage is applied to the control line CL1 to turn on the current control transistor 18. At this time, the voltage to be applied to the control line CL1 is controlled so that the channel resistance R_{CL} of the current control transistor 18 is sufficiently smaller than the resistance value R_{L} of the resistance memory element 12.

Simultaneously with turning on the current control transistor 18, a prescribed voltage is applied to the word line WL1 to turn on the cell select transistor 14. At this time, the voltage to be applied to the word line WL is controlled so that the channel resistance R_{cs} of the cell select transistor 14 becomes sufficiently smaller than the resistance value R_{L} of the resistance memory element 12 in the low resistance state.

The source line SL1 is connected to a reference potential, e.g., 0 V, which is the ground potential.

Next, to the bit line BL, a prescribed bias voltage is applied. This bias voltage is set in accordance with the memory characteristics given by the lowest current limitation value. That is, the value of the bias voltage is set so that even with the resistance memory element 12 in any resistance state, neither the setting nor the resetting is caused by the applied voltage.

When such the bias voltage is applied to the drain terminal of the bit line select transistor 16, current corresponding to the resistance value of the resistance memory element 12 flows in the bit line BL1. Accordingly, the value of the current flowing in the bit line BL1 is detected, whereby it can be read what resistance state the resistance memory element 12 has.

As described above, according to the present embodiment, when the resistance memory element is switched from the high resistance state to the low resistance state, the resistor is serially connected to the resistance memory element to thereby prevent the flow of large current to the resistance memory element, whereby the breakage and degradation of the resistance memory element due to the flow of the large current can be prevented. By the resistance value of the resistor, the resistance value of the resistance memory element in the low resistance state can be controlled. Thus, the multiple-valued memory can be easily realized.

### [A Fifth Embodiment]

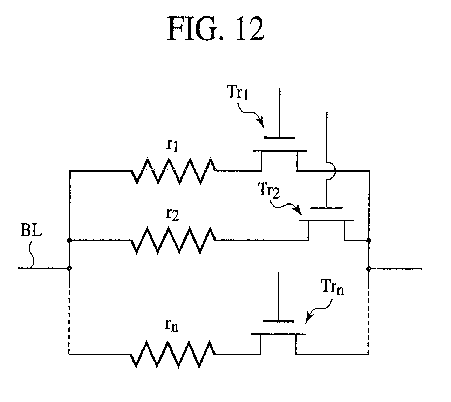

The nonvolatile semiconductor memory device and the method of writing into the same according to a fifth embodiment of the present invention will be explained with reference to FIG. 12. The same members of the present embodiment as those of the nonvolatile semiconductor memory device, the method of writing into the same and the method of reading the same according to first to the fourth embodiments shown in FIGs. 1 to 11 are represented by the same reference numbers not to repeat or to simplify their explanation.

FiG. 12 is a circuit diagram showing the structure of the nonvolatile semiconductor memory device according to the present embodiment.

In the first and the second embodiments, the channel resistance R_{BS} of the bit line select transistor 16 is controlled to thereby control the current to flow in the bit line BL, but the method for controlling the current to flow in the bit line BL is not limited to this. For example, the variable resistance circuit shown in FIG. 12 can be provided in place of the bit line select transistor 16 shown in FIG. 6.

The circuit shown in FIG. 12 is formed by parallelly connecting a plurality of series connection of the resistor r and the select transistor Tr. The resistance value of the resistor r₁, r₂, ..., rₙ are set suitably corresponding to the write/read characteristics of the nonvolatile semiconductor memory device.

By using the circuit shown in FIG. 12, at least one of the select transistors Tr₁, Tr₂, ... , or Trₙ is turned on, whereby the resistor r₁, r₂, ... , or rₙ are serially connected to the bit line BL. Accordingly, by the resistance value of the resistor r₁, r₂, ..., rₙ, the limitation value of the current to flow in the resistance memory element 12 in the setting can be suitably controlled. This current limitation value can be changed only by switching the select transistors Tr₁, Tr₂, ..., Trₙ to be turned on, which makes the control easy in comparison with controlling the channel resistance R_{BS} of the bit line select transistor 16.

In the resetting and the reading, the resistor having a sufficiently smaller resistance value than the resistance value R_{L} of the resistance memory element in the low resistance state (e.g., rₙ) may be connected, which also makes the control easy in comparison with controlling the channel resistance R_{BS} of the bit line select transistor 16.

Two or more of the select transistors Tr may be turned on at once. For example, in the circuit including the resistor r₁ and the resistor r₂, the resistance value with the select transistor Tr₁ turned on is r₁, and the resistance value with the select transistor Tr₂ turned on is r₂. The resistance value with the select transistors Tr₁, Tr₂ simultaneously turned on is r₁r₂/(r₁+r₂). Accordingly, by suitably combining the select transistors Tr to be turned on, more resistance states can be realized, which allows the circuit structure to be simplified.

As described above, according to the present embodiment, the resistance value of the resistor serially connected to the resistance memory elements can be easily controlled. Thus, a multiple-valued memory can be realized.

### [A Sixth Embodiment]

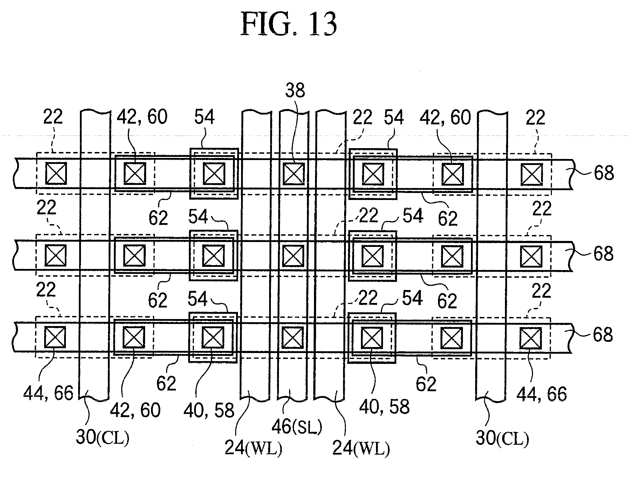

The nonvolatile semiconductor memory device and the method of manufacturing the same according to a sixth embodiment of the present invention will be explained with reference to FIGs 13 to 16.

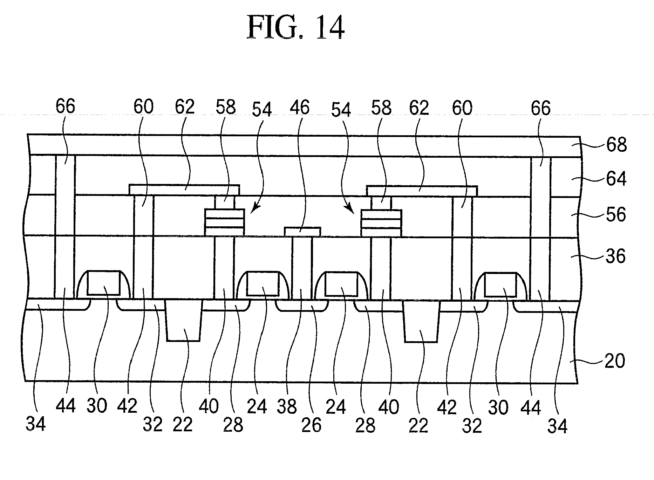

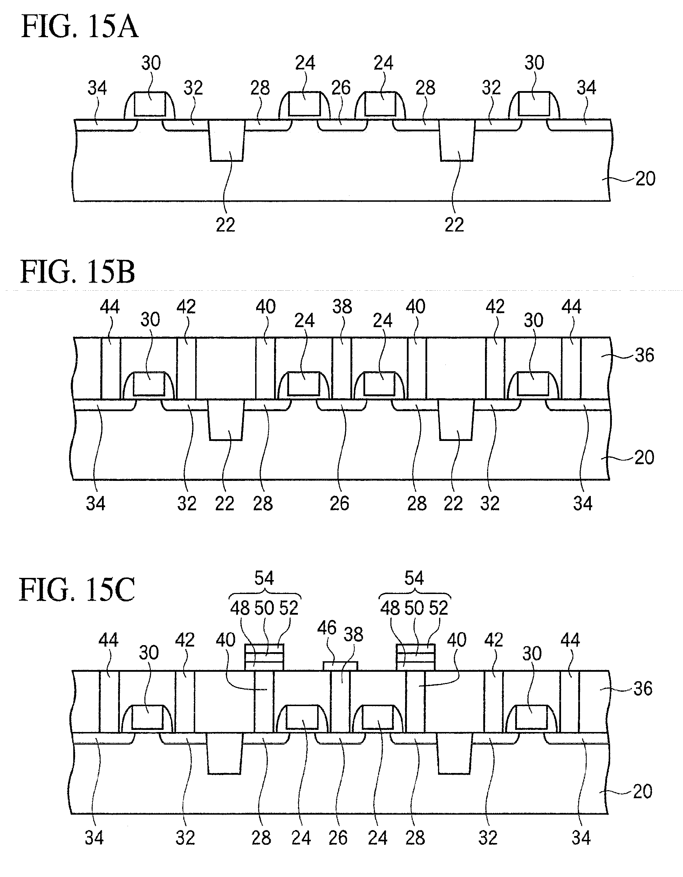

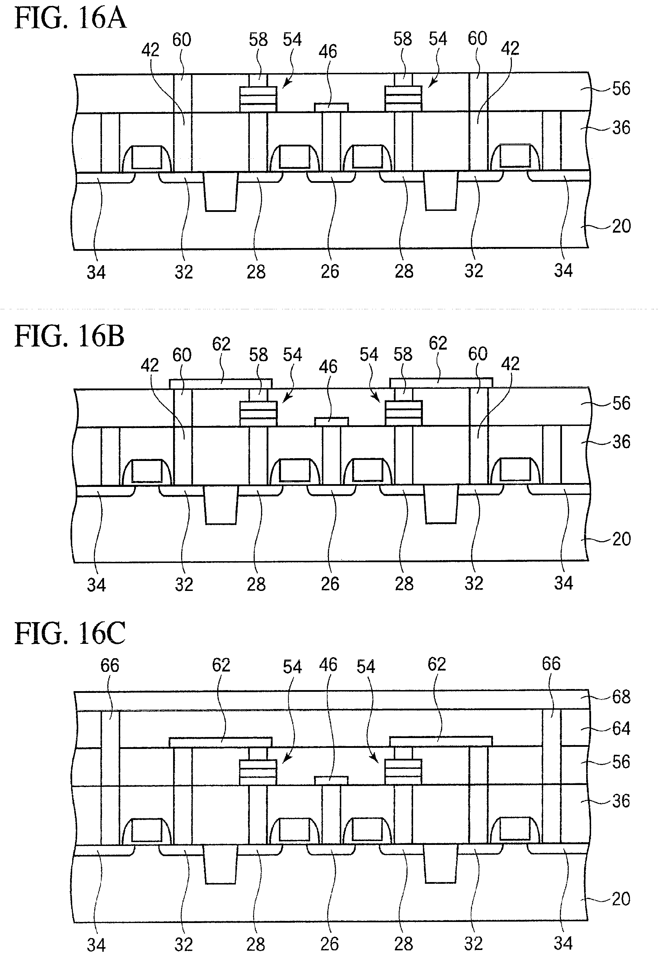

FIG. 13 is a plan view showing the structure of the nonvolatile semiconductor memory device according to the present embodiment. FIG. 14 is a diagrammatic sectional view showing the structure of the nonvolatile semiconductor memory device according to the present embodiment. FIGs. 15 and 16 are sectional views showing the method of manufacturing the nonvolatile semiconductor memory device according to the present embodiment.

In the present embodiment, the specific structure of the nonvolatile semiconductor memory device and the method of manufacturing the same according to the third embodiment described above will be explained.

First, the structure of the nonvolatile semiconductor memory device according to the present embodiment will be explained with reference to FIGs. 13 and 14.

In a silicon substrate 10, a device isolation film 22 for defining device regions is formed. In the device regions of the silicon substrate 20, cell select transistors each including a gate electrode 24 and source/drain regions 26, 28 and current control transistors each including a gate electrode 30 and source/drain regions 32, 34 are formed.

As shown in FIG. 13, the gate electrodes 24 function also as word lines WL commonly connecting the gate electrodes 24 of the cell select transistors adjacent in the column direction (vertically in the drawing), and the gate electrodes 30 function also as control lines CL commonly connecting the gate electrodes 30 of the current control transistors adjacent in the column direction.

Over the silicon substrate 10 with the cell select transistors and the current control transistors formed on, an inter-layer insulating film 36 with contact plugs 38 electrically connected to the source/drain regions 26, contact plugs 40 electrically connected to the source/drain regions 28, contact plugs 42 electrically connected to the source/drain regions 32 and contact plugs 44 electrically connected to the source/drain regions 34 buried in is formed.

Over the inter-layer insulating film 36 with the contact plugs 38, 40, 42, 44 buried in, the source lines 46 electrically connected to the source/drain regions 28 via the contact plugs 38, and resistance memory elements 54 electrically connected to the source/drain regions 30 via the contact plugs 40 are formed.

Over the inter-layer insulating film 36 with the source lines 46 and the resistance memory elements 54 formed on, an inter-layer insulating film 56 with contact plugs 58 electrically connected to the resistance memory elements 54 and contact plugs 60 electrically connected to the contact plugs 42 buried in is formed.

Over the inter-layer insulating film 56 with the contact plugs 58, 60 buried in, an interconnection layer 62 connecting between the contact plugs 58, 60 is formed.

Over the inter-layer insulating film 56 with the interconnection layer 62 formed on, an inter-layer insulating film 64 is formed. Over the inter-layer insulating film 64, bit lines 68 electrically connected to the source drain regions 34 via the contact plugs 66 buried in the inter-layer insulating films 64, 56 and the contact plugs 44 are formed.

Thus, the nonvolatile semiconductor memory device according to the third embodiment shown in FIG. 11 is constituted.

Next, the method of manufacturing the nonvolatile semiconductor memory device according to the present embodiment will be explained with reference to FIGs. 15 and 16.

First, in the silicon substrate 20, the device isolation film 22 for defining the device regions is formed by, e.g., STI (Shallow Trench Isolation) method.

Next, in the device regions of the silicon substrate 20, the cell select transistors each including the gate electrode 24 and the source/drain regions 26, 28 and the current control transistors each including the gate electrode 30 and the source/drain regions 32, 34 are formed in the same way as in the usual MOS transistor manufacturing method (FIG. 15A).

Next, over the silicon substrate 20 with the cell select transistors ad the current control transistors formed on, a silicon oxide film is deposited by, e.g., CVD method to form the inter-layer insulating film 36 of the silicon oxide film.

Next, by lithography and dry etching, the contact holes reaching down to the source/drain regions 26, 28, 32, 34 are formed in the inter-layer insulating film 36.

Next, by, e.g., CVD method, a barrier metal and a tungsten film are deposited, and then these conductive films are etched back to form the contact plugs 38, 40, 42, 44 electrically connected to the source/drain regions 26, 28, 32, 34 in the inter-layer insulating film 36 (FIG. 15B).

Next, over the inter-layer insulating film 36 with the contact plugs 38, 40, 42, 44 buried in, the source lines 46 electrically connected to the source/drain regions 26 via the contact plugs 38 and the resistance memory elements 54 electrically connected to the source/drain regions 28 via the contact plugs 40 are formed (FIG. 15C),

The resistance memory elements 54 each includes a lower electrode 40 connected to the contact plug 40, a resistance memory material layer 50 formed on the lower electrode 48 and an upper electrode 52 formed on the resistance memory material layer 50.

In the case that the resistance memory material layer 46 is formed of the bipolar resistance memory material, for example, Pr₁₋ₓCaₓMnO₃ (x ≤ 1), La₁₋ₓCaₓMnO₃ (x ≤ 1), SrTiO₃ doped with Cr, Nb or others, SrZrO₃ doped with Cr, Nb or others or others is formed by laser ablation, sol-gel method, sputtering method, MOCVD method or others. In the case that the resistance memory material layer 46 is formed of the unipolar resistance memory material, for example, a film of NiO_{y} (y ≤ 1), TiO_{z} (z ≤ 2), HfO_{z} (z ≤ 2) or others is formed by sol-gel method, sputtering method, MOCVD method or others.

Next, over the inter-layer insulating film 36 with the source lines 46 and the resistance memory elements 54 formed on, a silicon oxide film is deposited by, e.g., CVD method to form the inter-layer insulating film 56 of the silicon oxide film.

Next, by lithography and dry etching, in the inter-layer insulating film 56, contact holes reaching down to the upper electrodes 52 of the resistance memory elements 54 and contact holes reaching down to the contact plugs 42 are formed.

Next, a barrier metal and a tungsten film are deposited by, e.g., CVD method, and then these conductive films are etched back to form the contact plugs 58 electrically connected to the upper electrodes 52 of the resistance memory elements 54 and the contact plugs 60 electrically connected to the contact plugs 42 in the inter-layer insulating film 56 (FIG. 16A).

Then, over the inter-layer insulating film 56 with the contact plugs 58, 60 buried in, a conductive film is deposited, and then the conductive film is patterned by photolithography and dry etching to form the interconnection layer 62 electrically connected to the contact plugs 58 and the contact plugs 60 (FIG. 16B).

Next, over the inter-layer insulating film with the interconnection layer 62 formed on, a silicon oxide film is deposited by, e.g., CVD method to form the inter-layer insulating film 64 of the silicon oxide film.

Next, by lithography and dry etching, contact holes reaching down to the contact plugs 44 are formed in the inter-layer insulating films 64, 56.

Then, by, e.g., CVD method, a barrier metal and a tungsten film are deposited, and then these conductive films are etched back to form the contact plugs 66 electrically connected to the contact plugs 44 in the inter-layer insulating films 64, 56.

Then, over the inter-layer insulating film 64 with the contact plugs 66 buried in, a conductive film is deposited, and then the conductive film is patterned by photolithography and dry etching to form the bit lines 68 electrically connected to the source/drain regions 34 via the contact plugs 66, 44 (FIG. 16C).

Then, upper level interconnection layers are further formed as required, and the nonvolatile semiconductor memory device is completed.

### [Modified Embodiments]

The present invention is not limited to the above-described embodiments and can cover other various modifications.

For example, in the above-described embodiments, TiOₓ is used as the unipolar resistance memory material, and as the bipolar resistance memory material, Cr-doped SrZrO₃ is used. However, the material forming the resistance memory element is not limited to them. For example, as the unipolar resistance memory material, NiOₓ, etc. can be used, and as the bipolar resistance memory material, Pr₁₋ₓCaₓMnO₃ or La₁₋ₓCaₓMnO₃ exhibiting CMR (Colossal Magneto-Resistance), etc. can be used. It is preferable that the applied voltage and the current limitation value for the setting and the resetting are set suitably depending on kinds of the resistance memory material, structures of the resistance memory elements, etc.

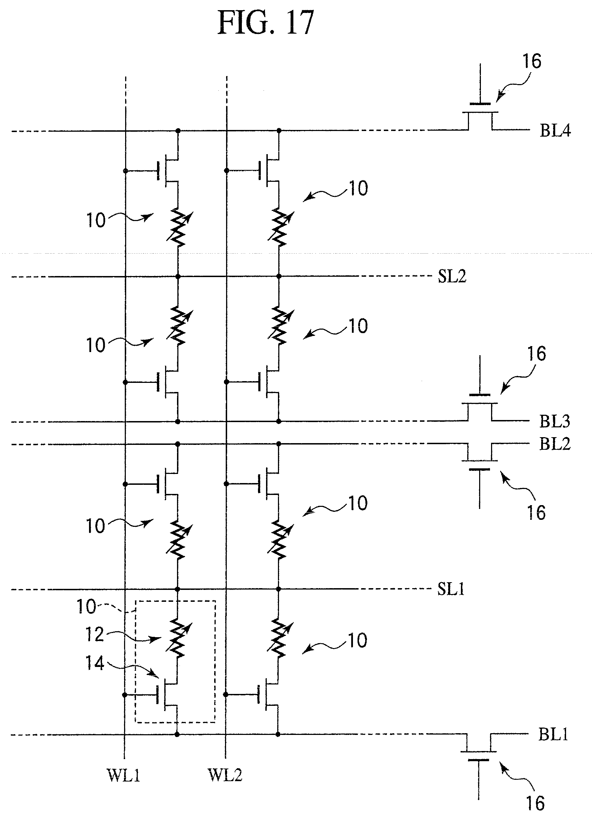

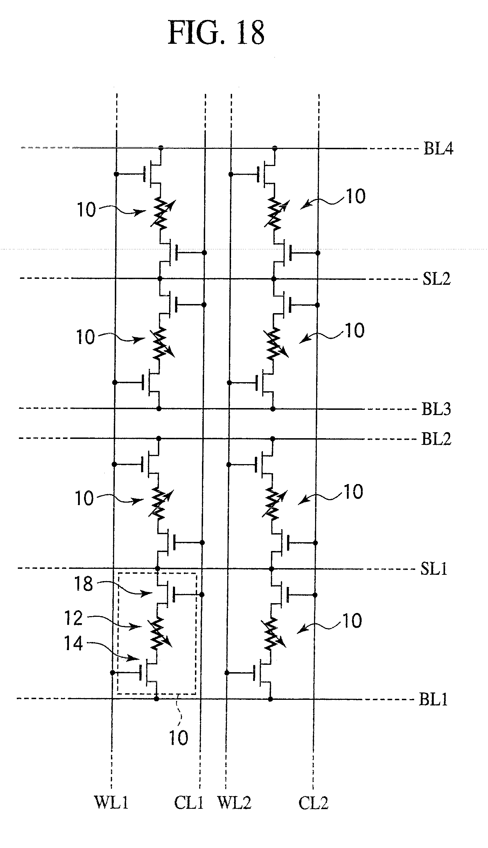

In the above-described embodiments, the source lines SL are arranged in parallel with the word lines WL but may be arranged in parallel with the bit lines BL. For example, in the nonvolatile semiconductor memory device according to the first and the second embodiments, as shown in FIG. 17, the source lines SL1, SL2 ... may be extended in row direction between the memory cells adjacent in column direction. Similarly, in the nonvolatile semiconductor memory device according to the third and the fourth embodiments, as shown in FIG. 18, the source lines SL1, SL2 ... may be extended in row direction between the memory cells adjacent in column direction.

In the above-described embodiments, one memory cell comprises one cell select transistor and one resistance memory element but may not have essentially this constitution. For example, one memory cell may comprise one cell select transistor and two resistance memory elements or two cell select transistors and two resistance memory elements. These constitutions will improve the read margin and other advantageous effects.

### INDUSTRIAL APPLICABILITY

The nonvolatile semiconductor memory device and the method of writing into the same according to the present invention can prevent the degradation of the elements when the resistance state is switched and can realize two or more resistance states with good reproducibility. Thus, the nonvolatile semiconductor memory device and the method of writing into the same according to the present invention are very useful to improve the reliability and memory capacity of the nonvolatile semiconductor memory devices.

## Claims

1. A method of writing into a nonvolatile semiconductor memory device including a resistance memory element which memorizes a high resistance state and a low resistance state and switches between the high resistance state and the low resistance state by an application of a voltage,
when the voltage is applied to the resistance memory element to thereby switch from the high resistance state to the low resistance state, a value of a current to flow in the resistance memory element being limited to thereby memorize the low resistance state of a low resistance value corresponding to the limited value of the current.

2. The method of writing into a nonvolatile semiconductor memory device according to claim 1, wherein
in memorizing the low resistance state of a first resistance value in the resistance memory element, the value of the current to flow in the resistance memory element is limited to a first current value, and
in memorizing the low resistance state of a second resistance value which is higher than the first resistance value in the resistance memory element, the value of the current to flow in the resistance memory element is limited to a second current value lower than the first current value.

3. The method of writing into a nonvolatile semiconductor memory device according to claim 1 or 2, wherein
the value of the current to flow in the resistance memory element is limited by a resistance value of a variable resistor serially connected to the resistance memory element.

4. The method of writing into a nonvolatile semiconductor memory device according to claim 3, wherein
the variable resistor is a MIS transistor, and
the resistance value of the variable resistor is controlled by a channel resistance of the MIS transistor.

5. The method of writing into a nonvolatile semiconductor memory device according to claim 3, wherein
the variable resistor includes a plurality of resistor parallelly connected, and
the resistance value of the variable resistor is controlled by selecting the resistor connected to the resistance memory element.

6. The method of writing into a nonvolatile semiconductor memory device according to any one of claims 3 to 5, wherein
when the voltage is applied to the resistance memory element to thereby switch from the low resistance state to the high resistance state, the resistance value of the variable resistor is controlled to be sufficiently smaller than a resistance value of the resistance memory element.

7. The method of writing into a nonvolatile semiconductor memory device according to any one of claims 1 to 5,
comprising a select transistor serially connected to the resistance memory element,
when the voltage is applied to the resistance memory element to thereby switch the resistance state, a channel resistance of the select transistor is controlled to be sufficiently smaller than a resistance value of the resistance memory element.

8. A nonvolatile semiconductor memory device comprising;
a resistance memory element which memorizes a high resistance state and a low resistance state and switches between the high resistance state and the low resistance state by an application of a voltage;
a variable resistor serially connected to the resistance memory element; and
a current limitation circuit which, when the voltage is applied to the resistance memory element to switch from the high resistance state to the low resistance stage, a value of a current to flow in the resistance memory element being limited to memorize in the resistance memory element the low resistance state of a low resistance value corresponding to the limited value of the current.

9. The nonvolatile semiconductor memory device according to claim 8, wherein
the variable resistor is a MIS transistor, and
the current limitation controls the resistance value of the variable resistor by a channel resistance of the MIS transistor.

10. The nonvolatile semiconductor memory device according to claim 8, wherein
the variable resistor includes a plurality of resistors parallelly connected, and
the resistor connecting to the resistance memory element is selected by the current limitation circuit to thereby control a resistance value of the variable resistor.

11. A nonvolatile semiconductor memory device comprising:
a plurality of memory cells arranged in a matrix, each including a resistance memory element which memorizes a high resistance state and a low resistance state and switches between the high resistance state and the low resistance state by an application of a voltage, and a select transistor having one terminal serially connected to one terminal of the resistance memory element;
a plurality of first signal lines parallelly extended in a first direction and each connected to gate electrodes of the select transistors of the memory cells arranged in the first direction;
a plurality of second signal lines parallelly extended in a second direction intersecting the first direction and each connected to the other terminals of the resistance memory elements of the memory cells arranged in the second direction;
a plurality of third signal lines parallelly extended in the first direction and each connected to the other terminals of the select transistors of the memory cells arranged in the first direction;
variable resistors serially connected to the other terminals of the resistance memory elements; and
a current limitation circuit which, when a voltage is applied to the resistance memory element to switch from the high resistance state to the low resistance state, controls a value of a current to flow in the resistance memory element to thereby memorize in the resistance memory element the low resistance state of a low resistance value corresponding to the limited value of the current.

12. The nonvolatile semiconductor memory device according to claim 11, wherein
the variable resistors are provided one for the respective plurality of second signal lines.

13. The nonvolatile semiconductor memory device according to claim 11, in which
the variable resistors are provided one for the respective plurality of memory cells, and which further comprises
a plurality of fourth signal lines which are parallelly extended in the first direction and each connected to gate electrodes of the variable resistors of the memory cells arranged in the first direction.
